# EUROPÄISCHE PATENTSCHRIFT

(11) **EP 2 376 278 B1**
(45) Veröffentlichungstag und Bekanntmachung des Hinweises auf die Patenterteilung: **26.12.2012**
(21) Anmeldenummer: 09759907.0
(22) Anmeldetag: 28.11.2009
(51) Int. Cl.: B32B 3/20, B32B 3/30, B32B 27/08, B06B 1/06, H01L 41/193

(54) **FERROELEKTRET-MEHRSCHICHTVERBUND UND VERFAHREN ZUR HERSTELLUNG EINES FERROELEKTRET-MEHRSCHICHTVERBUNDS MIT PARALLELEN RÖHRENFÖRMIGEN KANÄLEN**
FERROELECTRET MULTILAYER COMPOSITE AND METHOD FOR PRODUCING A FERROELECTRET MULTILAYER COMPOSITE WITH PARALLEL TUBULAR CHANNELS
COMPOSITE MULTICOUCHE À FERROÉLECTRET ET PROCÉDÉ DE FABRICATION D'UN COMPOSITE MULTICOUCHE À CANAUX TUBULAIRES PARALLÈLES

(30) Priorität: 13.12.2008 EP 08021693
(43) Veröffentlichungstag der Anmeldung: 19.10.2011
(73) Patentinhaber: Bayer MaterialScience AG, 51368 Leverkusen (DE)
(72) Erfinder: JENNINGER, Werner, 50677 Köln (DE); WAGNER, Joachim, 51061 Köln (DE); GERHARD, Reimund, 10623 Berlin (DE); ALTAFIM, Ruy, Alberto, CEP-13564-330 Sao Carlos, SP (BR); WIRGES, Werner, 14532 Kleinmachnow (DE)
(86) Internationale Anmeldenummer: PCT/EP2009/008478
(87) Internationale Veröffentlichungsnummer: WO 2010/066347

(56) Entgegenhaltungen:
- WO-A-99/48621
- DE-A1- 19 727 722
- ALTAFIM ET AL: "Piezoelectrets from thermo-formed bubble structures of fluoropolymer-electret films" IEEE TRANSACTIONS ON DIELECTRICS AND ELECTRICAL INSULATION, IEEE SERVICE CENTER, PISCATAWAY, NJ, US, Bd. 13, Nr. 5, 1. Oktober 2006 (2006-10-01), Seiten 979-985, XP011142331 ISSN: 1070-9878 in der Anmeldung erwähnt
- ZHANG X ET AL: "Thermally stable fluorocarbon ferroelectrets with high piezoelectric coefficient" APPLIED PHYSICS A; MATERIALS SCIENCE & PROCESSING, SPRINGER, BERLIN, DE LNKD- DOI:10.1007/S00339-006-3573-5, Bd. 84, Nr. 1-2, 7. April 2006 (2006-04-07), Seiten 139-142, XP019424358 ISSN: 1432-0630 in der Anmeldung erwähnt
- ALTAFIM RUY ET AL: "Template-based fluoroethylenepropylene piezoelectrets with tubular channels for transducer applications" JOURNAL OF APPLIED PHYSICS, AMERICAN INSTITUTE OF PHYSICS. NEW YORK, US LNKD- DOI:10.1063/1.3159039, Bd. 106, Nr. 1, 9. Juli 2009 (2009-07-09), Seiten 14106-14106, XP012123453 ISSN: 0021-8979

## Beschreibung

Die vorliegende Erfmdung betrifft einen Ferroelektret-Mehrschichtverbund und ein Verfahren zur Herstellung eines Ferroelektret-Mehrschichtverbunds mit röhrenförmigen, insbesondere parallel zueinander verlaufenden Kanälen.

Wegen ihrer vorteilhaften und gezielt einstellbaren Eigenschaften, wie zum Beispiel geringes Gewicht, thermische Leitfähigkeit, mechanische Verformbarkeit, elektrischen Eigenschaften sowie Barriereeigenschaften, werden Polymere und Polymerverbundstoffe in einer Vielzahl von kommerziellen Anwendungen eingesetzt. Sie werden beispielsweise als Verpackungsmaterial für Lebensmittel oder sonstige Güter, als Konstruktions- oder Isolationsmaterialien beispielsweise im Bauwesen oder im Fahrzeugbau verwendet. Funktionspolymere gewinnen in zunehmendem Maße aber auch als aktive Komponenten in Sensor- oder Aktoranwendungen an Bedeutung. Ein wichtiges Anwendungskonzept bezieht sich dabei auf den Einsatz der Polymere als elektromechanische, oder piezoelektrische Wandler. Piezoelektrische Materialien sind in der Lage, einen mechanischen Druck linear in ein elektrisches Spannungssignal umzuwandeln. Umgekehrt kann ein an das piezoelektrische Material angelegtes elektrisches Feld in eine Änderung der Wandlergeometrie transformiert werden. Piezoelektrische Polymere werden bereits in einer Vielzahl von Anwendungen als aktive Komponenten integriert. Hierzu gehören beispielsweise strukturierte Drucksensoren für Tastaturen oder Touchpads, Beschleunigungssensoren, Mikrofone, Lautsprecher, Ultraschallwandler für Anwendungen in der Medizintechnik, der Meerestechnik oder zur Materialprüfung. In der WO 2006/053528 A1 ist beispielsweise ein elektroakustischer Wandler auf Basis eines piezoelektrischen Elements aus Polymerfolien beschrieben.

In den letzten Jahren steht zunehmend eine neue Klasse piezoelektrischer Polymere, die so genannten Ferroelektrete, im Interesse der Forschung. Die Ferroelektrete werden auch Piezoelektrete genannt. Ferroelektrete bestehen aus Polymermaterialien, die elektrische Ladungen über lange Zeiträume speichern können und weisen zusätzlich eine Hohlraumstruktur auf. Die bisher bekannten Ferroelektrete weisen eine zelluläre Hohlraumstruktur auf und sind entweder als geschäumte Polymerfolien oder als Mehrschichtsysteme aus Polymerfolien oder Polymergeweben ausgebildet. Sind elektrische Ladungen entsprechend ihrer Polarität auf den unterschiedlichen Oberflächen der Hohlräume verteilt, stellt jeder geladene Hohlraum einen elektrischen Dipol dar. Werden die Hohlräume nun deformiert, bedingt dies eine Änderung der Dipolgröße und führt zu einem Stromfluss zwischen äußeren Elektroden. Die Ferroelektrete können eine piezoelektrische Aktivität zeigen, die der anderer Piezoelektrika vergleichbar ist.

In der US 4,654,546 ist ein Verfahren zur Herstellung von Polypropylen-Schaumfolien als Vorstufe zu einer Ferroelektretfolie beschrieben. Hierbei werden die Polymerfolien mit Füllstoffpartikeln versetzt. Als Füllstoff wird zum Beispiel Titandioxid eingesetzt. Die Polypropylenfolien werden nach dem Extrudieren biaxial gereckt, so dass sich rund um die Füllstoffpartikel kleine Hohlräume in der Folie ausbilden. Dieses Verfahren wurde inzwischen auch auf andere Polymere angewendet. So wurde zum Beispiel in M. Wegener, M. Paajanen, O. Voronina, R. Schulze, W. Wirges, and R. Gerhard-Multhaupt "Voided cyclo-olefin polymer films: Ferroelectrets with high thermal stability", Proceedings, 12th International Symposium on Electrets (IEEE Service Center, Piscataway, New Jersey, USA 2005), 47-50 (2005) und Eetta Saarimäki, Mika Paajanen, Ann-Mari Savijärvi, and Hannu Minkkinen, Michael Wegener, Olena Voronina, Robert Schulze, Werner Wirges and Reimund Gerhard-Multhaupt "Novel Heat Durable Electromechanical Film: Processing for Electromechanical and Electret Applications", IEEE Transactions on Dielectrics and Electrical Insulation 13, 963-972 (October 2006), die Herstellung von Ferroelektretfolien aus Cyclo-Olefin-Copolymeren (COC) und Cyclo-Olefin-Polymeren (COP) beschrieben. Die geschäumten Polymerfolien haben den Nachteil, dass sich eine breite Verteilung der Bläschengröße ergeben kann. Dadurch können bei dem anschließenden Aufladungsschritt nicht alle Blasen gleichmäßig gut aufgeladen werden. Zusätzlich muss sich bei einer Herstellung von geschäumten Polymerfolien in einem kontinuierlichen Rolle-zu-Rolle-Prozess in der Regel ein weiterer Prozessschritt zur Optimierung der Bläschengröße anschließen, der wiederum einem Rolle-zu-Rolle-Prozess nicht zugänglich ist.

Ein weiteres Verfahren zur Herstellung geschäumter Ferroelektret-Polymerfolien ist das direkte physikalische Schäumen einer homogenen Folie mit superkritischen Flüssigkeiten, zum Beispiel mit Kohlendioxid. In Advanced Functional Materials 17, 324-329 (2007), Werner Wirges, Michael Wegener, Olena Voronina, Larissa Zirkel, and Reimund Gerhard-Multhaupt "Optimized preparation of elastically soft, highly piezoelectric, cellular ferroelectrets from nonvoided poly(ethylene terephthalate) films", und in Applied Physics Letters 90, 192908 (2007), P. Fang, M. Wegener, W. Wirges, and R. Gerhard L. Zirkel "Cellular polyethylene-naphthalate ferroelectrets: Foaming in supercritical carbon dioxide, structural and electrical preparation, and resulting piezoelectricity", ist dieses Verfahren mit Polyestermaterialien sowie in Applied Physics A: Materials Science & Processing 90, 615-618 (2008), O. Voronina, M. Wegener, W. Wirges, R. Gerhard, L. Zirkel, and H. Münstedt "Physical foaming of fluorinated ethylene-propylene (FEP) copolymers in supercritical carbon dioxide: single film fluoropolymer piezoelectrets" für ein Fluorpolymer FEP (Fluorinated Ethylene-Propylene Copolymer) beschrieben worden. Der Schäumungsprozeß mit superkritischem Kohlendioxid ist bisher ebenfalls nicht in einem Rolle-zu-Rolle-Prozess durchzuführen, was einen wesentlichen Nachteil des Verfahrens für die industrielle Anwendung bedeutet.

Bei den Ferroelektret-Mehrschichtsystemen sind unter anderem Anordnungen aus harten und weichen Schichten und dazwischen eingebrachten Ladungen bekannt. In "Double-layer electret transducer", Journal of Electrostatics, Vol. 39, pp. 33-40, 1997, R. Kacprzyk, A. Dobrucki, and J. B. Gajewski, sind Mehrfachschichten aus festen Materialien mit stark unterschiedlichen Elastizitätsmodulen beschrieben. Diese haben den Nachteil, dass diese Schichtsysteme nur einen relativ geringen piezoelektrischen Effekt zeigen.

Neueste Entwicklungen auf dem Gebiet der Ferroelektrete sehen strukturierte Polymerschichten vor. In mehreren Veröffentlichungen aus den letzten Jahren sind Mehrschichtsysteme aus geschlossenen äußeren Schichten und einer porösen oder perforierten Mittelschicht beschrieben. Hierzu gehören die Artikel von Z. Hu and H. von Seggern, "Air-breakdown charging mechanism of fibrous polytetrafluoroethylene films", Journal of Applied Physics, Vol. 98, paper 014108, 2005 und "Breakdown-induced polarization buildup in porous fluoropolymer sandwiches: A thermally stable piezoelectret", Journal of Applied Physics, Vol. 99, paper 024102, 2006, sowie die Veröffentlichung von H.C. Basso, R.A.P. Altafilm, R.A.C. Altafilm, A. Mellinger, Peng Fang, W. Wirges, and R. Gerhard "Three-layer ferroelectrets from perforated Teflon -PTFE films fused between two homogeneous Teflon -FEP films" IEEE, 2007 Annual Report Conference on Electrical Insulation and Dielectric Phenomena, 1-4244-1482-2/07, 453-456 (2007) und der Artikel von Jinfeng Huang, Xiaoqing Zhang, Zhongfu Xia, and Xuewen Wang "Piezoelectrets from laminated sandwiches of porous polytetrafluoroethylene films and nonporous fluoroethylenepropylene films" Journal of Applied Physics, Vol. 103, paper 084111, 2008. Die Schichtsysteme mit einer porösen oder perforierten Mittelschicht haben gegenüber den vorstehend beschriebenen Systemen größere Piezokonstanten. Dabei lassen sich die Mittelschichten jedoch manchmal nicht zuverlässig mit den festen Außenschichen laminieren. Darüber hinaus ist die Perforation der Mittelschicht in der Regel sehr zeitaufwendig.

In den Veröffentlichungen von X. Zhang, J. Hillenbrand und G. M. Sessler, "Thermally stable fluorocarbon ferroelectrets with high piezoelectric coefficient". Applied Physics A, Vol. 84, pp. 139-142, 2006 und "Ferroelectrets with improved thermal stability made from fused fluorocarbon layers", Journal of Applied Physics, Vol. 101, paper 054114, 2007, sowie in Xiaoqing Zhang, Jinfeng Huang and Zhongfu Xia "Piezoelectric activity and thermal stability of cellular fluorocarbon films" PHYSICA SCRIPTA Vol. T129 pp 274-277, 2007 ist die Strukturierung der Polymerschichten durch Aufdrücken eines Metallgitters auf einen Polymerschichtstapel aus mindestens drei in alternierender Reihenfolge übereinander gelagerten FEP- und PTFE-Schichten beschrieben. Durch das Zusammenpressen der Schichten durch das Gitter bei einer Temperatur, die über dem Schmelzpunkt von FEP und unter dem von PTFE liegt, werden die Polymerschichten entsprechend der Gitterstruktur derart miteinander verbunden, dass sich zwischen den Gitterstäben kuppelförmige oder blasenförmige Hohlräume mit rechteckiger Grundfläche bilden. Dieses Verfahren führt jedoch zu Ferroelektreten mit unterschiedlicher Qualität, da die Bildung gleichförmiger Hohlräume vor allem bei zunehmender Schichtenanzahl nur schwer kontrolliert werden kann.

Ein anderes Verfahren zur Herstellung blasenförmiger Hohlräume unter Verwendung eines Gitters ist durch R. A. C. Altafim, H. C. Basso, R. A. P. Altafim, L. Lima, C. V. De Aquino, L. Gonalves Neto and R. Gerhard-Multhaupt, in "Piezoelectrets from thermo-formed bubble structures of fluoropolymer-electret films", IEEE Transactions on Dielectrics and Electrical Insulation, Vol. 13, No.5, pp. 979-985, 2006 beschrieben worden. Hierbei werden zwei übereinander angeordnete Teflon-FEP-Folien zwischen einem Metallgitter und einem oberen zylinderförmigen Metallteil angeordnet. Dieser Aufbau wird mit dem Metallgitter auf ein unteres zylinderförmiges Metallteil aufgepresst, welches Öffnungen zur Anlegung eines Vakuums aufweist. Die FEP-Folien werden durch das obere Metallteil erhitzt und durch ein an das untere Metallteil angelegtes Vakuum wird die untere Folie in die Öffnungen des Gitters gezogen und entsprechende Hohlräume gebildet. Die beschriebenen Verfahren unter Verwendung eines Gitters zur Ausbildung von Hohlräumen in den Polymer-Mehrschichtverbunden sind aufwendig und schwierig in den großtechnischen Maßstab zu übertragen.

Ferroelektrete sind für kommerzielle Anwendungen, beispielsweise für Sensor- und Aktorsysteme weiterhin von zunehmendem Interesse. Für die Wirtschaftlichkeit ist dabei eine Anwendbarkeit eines Herstellungsverfahrens im industriellen Maßstab essentiell.

Der Erfindung liegt daher die Aufgabe zu Grunde, einen alternativen Ferroelektret-Mehrschichtverbund sowie ein alternatives Verfahren zur Herstellung eines Ferroelektret-Mehrschichtverbunds bereitzustellen, mit dem eine definierte Ferroelektret-Hohlraumstruktur erzeugt werden kann und das einfach und kostengünstig auch im großtechnischen und industriellen Maßstab durchführbar ist.

Diese Aufgabe wird erfindungsgemäß durch einen Ferroelektret-Mehrschichtverbund gemäß Anspruch 1 und ein Verfahren zur Herstellung eines Ferroelektret-Mehrschichtverbunds mit parallelen röhrenförmigen Kanälen gemäß Anspruch 7 gelöst.

Erfindungsgemäß wird ein Ferroelektret-Mehrschichtverbund bereitgestellt, der mindestens zwei übereinander angeordnete und miteinander verbundene Polymerfolien umfasst wobei zwischen den Polymerfolien Hohlräume ausgebildet sind und die Hohlräume als röhrenförmige Kanäle ausgestaltet sind. Besonders bevorzugt verlaufen die röhrenförmigen Kanäle parallel zueinander.

Die erfindungsgemäßen Mehrschichtverbunde weisen mit anderen Worten stapelförmig geschichtete Polymerfolien und zwischen jeweils zwei Polymerfolien lang gestreckte, besonders bevorzugt in parallelen Linien verlaufende Kanäle als Hohlräume auf. Die Polymerfolien sind zwischen den Kanälen miteinander verbunden und bilden jeweils in den unverbundenen Teilen die Wände der rohrförmigen Kanäle. Hierbei sind im Bereich der Fertigungstoleranzen unter Anderem in der parallelen Ausrichtung auch Abweichungen von bis zu 10 % möglich. Die parallelen Kanäle, die erfindungsgemäß zwischen zwei Schichten aus Polymerfolien gebildet sind, werden erfindungsgemäß auch als eine Lage Kanäle bezeichnet.

Die Kanäle können in bevorzugten Ausgestaltungen der Erfindung zu ihren Stirnseiten hin offen oder ein- oder beidseitig geschlossen sein. Die Kanäle können auch nebeneinander beispielsweise in periodischen oder auch unregelmäßigen Abständen geöffnet und geschlossen ausgeführt sein.

Die geschlossenen Kanäle haben den Vorteil, dass diese hermetisch von der Umwelt abgeschlossen sind. Sie können daher mit versiegelten, also geschlossenen, Kanälen auch in Anwendungen in einer aggressiven Umgebung, beispielsweise bei Atmosphären mit hoher Luftfeuchtigkeit oder unter Wasser eingesetzt werden.

In einer weiter bevorzugten Ausführungsform der Erfindung kann in die geschlossenen Kanäle ein Gas eingefüllt werden. Das Gas kann dabei beispielsweise reiner Stickstoff (N₂), Stickstoffoxid (N₂O) oder Schwefelhexafluorid (SF₆) sein. Durch die Gasbefüllung können vorteilhafterweise bei dem erfindungsgemäßen Ferroelektret-Mehrschichtverbund nochmals deutlich höhere Piezokonstanten erzielt werden.

Grundsätzlich können die Polymerfolien dabei aus jedem Kunststoff gefertigt sein, der eine Verbindung zwischen den Polymerfolien und eine Ausbildung von Kanälen zwischen den Folien erlaubt. Die Polymerfolien können erfindungsgemäß in einer bevorzugten Ausgestaltung aus gleichen oder unterschiedlichen Polymermaterialien ausgewählt aus der Gruppe der Polycarbonate, perfluorierten oder teilfluorierten Polymere - und Copolymere, Polyester, Cyclo-Olefin-Polymere, Cyclo-Olefin-Copolymere, Polyimide, Polymethylmethacrylat und Polypropylen oder Polymerblends bestehen. Mit diesen Materialien können gute bis sehr gute Piezoaktivitäten erzielt werden. Die erfindungsgemäß breite Materialauswahl kann vorteilhafterweise auch eine Anpassung auf bestimmte Anwendungen ermöglichen.

Die Polymerfolien können bevorzugt eine Dicke von ≥ 10 µm bis ≤ 200 µm aufweisen. Die Dicke der verschiedenen Polymerfolien in einem erfindungsgemäßen Ferroelektret-Mehrschichtverbund kann dabei gleich oder unterschiedlich gewählt werden. Eine besonders geeignete Dicke der Polymerfolien kann dabei vorteilhafterweise jeweils in Abhängigkeit des Polymermaterials und im Hinblick auf die angestrebte Anwendung ausgewählt werden. Es kommt grundsätzlich darauf an, dass die röhrenförmigen Kanäle als Hohlräume nicht kollabieren. So können steifere Materialien dünner ausgeführt werden als vergleichsweise elastischere Polymermaterialien.

Die Polymerfolien können als Folienblätter oder insbesondere im Hinblick auf eine großtechnische Herstellung vorteilhafterweise auch als Folienbahnen ausgestaltet sein, die übereinander angeordnet und unter Ausbildung der röhrenförmigen Kanäle miteinander verbunden werden können. Die Folienblätter können dabei beispielsweise eine rechteckige, eine regelmäßige oder unregelmäßige Vieleckform oder eine runde, beispielsweise kreisförmige, elliptische oder ovale Grundfläche aufweisen, wobei die übereinander angeordneten Folien zweckmäßigerweise, zumindest im übereinander angeordneten Bereich, die gleiche Grundfläche aufweisen. Grundsätzlich kann die Grundfläche auch an eine spezielle Anwendung angepasst werden.

In einer bevorzugten Ausgestaltung des erfindungsgemäßen Ferroelektret-Mehrschichtverbunds können drei oder mehr Polymerfolien übereinander angeordnet und miteinander verbunden sein, wobei die bevorzugt parallel zueinander verlaufenden Kanäle, zwischen den Polymerfolien in übereinander angeordneten Lagen parallel oder senkrecht zueinander angeordnet sein können. Mit anderen Worten kann sich in einer gedachten Draufsicht auf einen solchen Mehrschichtverbund auch eine gitterförmige Anordnung der in aufeinander folgenden Lagen angeordneten parallelen Kanäle ergeben. Erfindungsgemäß können die Kanäle in einer Gitteranordnung nicht nur im rechten Winkel zueinander angeordnet sein, sondern es sind auch andere Winkelanordnungen zueinander möglich und erfindungsgemäß umfasst. Sind die Kanäle in den aufeinander folgenden Lagen parallel zueinander ausgerichtet, können sie direkt übereinander oder versetzt zueinander angeordnet sein. Bei der parallelen Ausrichtung der Kanäle in den aufeinanderfolgenden Lagen ist eine versetzte Anordnung zu bevorzugen, da dadurch der piezoelektrische Effekt gleichmäßiger und die Oberflächenstrukturierung des Ferroelektret-Mehrschichtverbunds minimiert werden kann. Vorteilhafterweise kann mit diesen erfindungsgemäßen Varianten, in denen drei oder mehr Polymerfolien und entsprechend mehrere Lagen von röhrenförmigen Kanälen im Ferroelektret-Mehrschichtverbund vorgesehen werden können, gegenüber denen mit nur zwei Polymerfolien weicher gestaltet und durch die zusätzlichen vorhandenen Hohlräume die Empfindlichkeit des Verbunds und damit die d33-Piezoelektrische Konstante erhöht werden.

In einer bevorzugten erfindungsgemäßen Ausführungsform des erfindungsgemäßen Ferroelektret-Mehrschichtverbunds können die Kanäle eine Höhe ≥ 10 µm bis ≤ 500 µm aufweisen. Mit der Höhe ist insbesondere die maximale Höhe der röhrenförmigen Kanäle im Querschnitt gemeint. Die Höhe kann beispielsweise, wie bei einer im Wesentlichen rechteckigen Ausgestaltung der Kanäle über die Breite der Kanäle gleich bleiben oder von den Seiten zur Mitte hin ansteigen. Besonders bevorzugt können die Kanäle eine Höhe von ≥ 25 µm bis ≤ 250 µm und ganz besonders bevorzugt von ≥ 50 µm bis ≤150 µm aufweisen.

Die röhrenförmigen Kanäle können gleich oder unterschiedlich dimensioniert sein. Erfindungsgemäß ist es beispielsweise möglich, alternierend breite und schmale Kanäle bereitzustellen. Eine solche Anordnung der Kanäle kann beispielsweise vorteilhaft in einer Anwendung eingesetzt werden, in der der Verbund gebogen, beispielsweise zylinderförmig geführt oder gelegt und verwendet werden soll. Es ist auch möglich in einem erfindungsgemäß bereitgestellten Ferroelektret-Mehrschichtverbund jeweils Teilbereiche mit schmalen und/oder breiten Kanälen vorzusehen. Hierdurch kann die Empfindlichkeit entsprechend bereichsweise eingestellt werden. Eine beispielhafte Anwendung hierfür, in der sich dies vorteilhaft nutzen lässt, ist die bereichsweise Einstellung der Druckempfindlichkeit auf einem Touchpad.

In verschiedenen Ausführungsformen können die Kanäle einen im Wesentlichen rechteckigen oder im Wesentlichen runden Querschnitt aufweisen. Unter einem im Wesentlichen runden Querschnitt werden kreisförmige, elliptische oder ovale Formen verstanden. Es sind aber auch linsen- oder mandelartige Formen möglich. Die genannten Querschnittformen sind vorteilhafterweise leicht herstellbar. Grundsätzlich sind erfindungsgemäß jedoch auch andere regelmäßige und unregelmäßige Querschnittsformen der Kanäle möglich.

In einer bevorzugten Ausgestaltung kann der erfindungsgemäße Ferroelektret-Mehrschichtverbund auf den nach außen gerichteten Oberflächen der Polymerfolien mindestens teilweise eine leitende Beschichtung aufweisen. Diese leitenden Bereiche können als Elektroden genutzt werden. Die leitende Beschichtung, dass heißt die Elektroden, können dabei flächig und/oder auch strukturiert aufgebracht werden. Eine strukturierte leitende Beschichtung kann beispielsweise als eine Aufbringung in Streifen oder in Gitterform ausgestaltet sein. Hierdurch kann zusätzlich die Empfindlichkeit des Ferroelektret-Mehrschichtverbunds beeinflusst und auf bestimmte Anwendungen angepasst werden. Diese Variante kann beispielsweise dann vorteilhaft eingesetzt werden, wenn durch die Vergrößerung der Polymerfolien-Schichtenanzahl mit röhrenförmigen Kanälen keine Steigerung des piezoelektrischen Effekts mehr erzielt werden kann.

Erfindungsgemäß umfasst ist auch, dass zwei oder mehr Ferroelektret-Mehrschichtverbunde mit gleich gepolter leitender Schicht, das heißt also Elektrode, verbunden werden können. Mit anderen Worten kann zwischen zwei erfindungsgemäßen Ferroelektret Mehrschichtverbunden eine Zwischenelektrode gebildet werden, die gegen die beiden Elektroden auf den äußeren Oberflächen geschaltet werden kann. Hierdurch können die Ferroelektret-Mehrschichtverbunde in Reihe geschaltet und der piezoelektrische Effekt verdoppelt, bzw. vervielfacht werden.

Die Erfindung betrifft weiterhin ein Verfahren zur Herstellung eines Ferroelektret-Mehrschichtverbunds mit parallelen röhrenförmigen Kanälen. Bei dem erfindungsgemäßen Verfahren ist vorgesehen, die folgenden Schritte auszuführen:
a) Bereitstellen eines Schichtenstapels enthaltend eine erste Polymerfolie, eine zweite Polymerfolie und eine dazwischen angeordnete Maskenschicht, wobei die Maske innerhalb des Schichtenstapels einen oder mehrere voneinander durch Aussparungen beabstandete, insbesondere parallele, Stege aufweist, wobei die Stege auf mindestens einer Stirnseite nicht verbunden oder voneinander trennbar verbunden sind und die Maske an einer oder beiden Stirnseiten aus dem Schichtstapel herausragt,
b) Laminieren des in Schritt a) erzeugten Schichtenstapels und Verbinden der Polymerfolien zu einem Polymerfolienverbund,
c) gegebenenfalls Trennen der Stege der Maske an einer Stirnseite,
d) Entfernen der Maske aus dem Polymerfolienverbund durch Herausziehen der Maske aus dem Polymerfolienverbund
e) Elektrische Aufladung der inneren Oberflächen der in Schritt d) freigegebenen röhrenförmigen Kanäle mit entgegen gesetzten elektrischen Ladungen.

Mit dem erfindungsgemäßen Verfahren können auf einfache Weise Ferroelektret-MehrschichtSysteme mit definierten parallelen röhrenförmigen Kanälen hergestellt werden. Durch die Verwendung der Maske können Struktur und Form der Kanäle sehr einfach und genau kontrolliert werden. Es ist daher erfindungsgemäß möglich, gleichförmige Kanäle zu erzeugen. Unterschiedliche Resonanzfrequenzen, wie sie bei geschäumten Ferroelektret-Folien durch ungleichförmige Blasen auftreten, können somit vermieden werden. Mit der erfindungsgemäßen Vorgehensweise ist es außerdem möglich, Resonanzfrequenz und Piezoaktivität, und insbesondere die piezoelektrische d33 Konstante, auf die jeweilige Anwendung einzustellen. Vorteilhafterweise können mit den erfindungsgemäß hergestellten Ferroelektret-Mehrschichtverbund-Systemen hohe und gleichmäßige piezoelektrische Koeffizienten auch für größere Flächen erzielt werden. Dies erschließt diese Ferroelektret-Mehrschichtverbund-Produkte für zahlreiche weitere Verwendungen. Ein zusätzlicher Vorteil ist, dass der erfindungsgemäß vorgeschlagene Prozess weitgehend materialunabhängig ist. Die Polymerfolien können grundsätzlich aus jedem Polymermaterial gefertigt sein, das sich laminieren lässt. Beispiele hierfür sind Polycarbonat, perfluorierte oder teilfluorierte Polymere wie PTFE, Fluorethylenpropylen (FEP), Perfluoralkoxyethylene (PFA), Polypropylen, Polyester, wie Polyethylenterephthalat (PET) oder Polyethylennaphthalat (PEN), Cyclo-Olefin-Polymere, Cyclo-Olefin-Copolymere, Polyimide, Polymethylmethacrylat (PMMA) oder Polymerblends.

Die Maske ist zweckgemäß aus einem Material gefertigt und ausgewählt, das sich unter den jeweils gewählten Betriebsbedingungen nicht mit dem oder den Polymerfolienmaterialien verbindet.

In der einfachsten Ausführungsform des Verfahrens kann die Maske ein Polymerfolienblatt, beispielsweise aus Polytetrafluoroethylen (PTFE) sein, in das parallele lang gestreckte rechteckige Aussparungen eingeschnitten oder gestanzt sind, so dass die Stege als parallele Folien-Streifen ausgebildet werden, die zu beiden Stirnseiten der Masken-Polymerfolie miteinander verbunden sind. Dies hat den Vorteil, dass die Stege an beiden Stirnseiten fixiert sind und bei einer manuellen Handhabung und Durchführung des Verfahrens nicht verrutschen oder verformt werden. Die Maske kann dann zwischen zwei übereinander angeordnete Polymerfolienblätter, beispielsweise aus Fluor-Ethylen-Propylen (FEP) eingelegt werden, wobei die Stirnseiten der Maske aus dem gebildeten Schichtenstapel herausragen. Der Schichtenstapel kann nachfolgend bei einer geeigneten erhöhten Temperatur laminiert werden. Hierbei verbinden sich die FEP-Polymerfolien in den Aussparungen der Maske und bilden die Form der Stege ab. An einer Stirnseite können die Stege dann voneinander getrennt werden, so dass die Maske eine kammartige Form erhält und leicht aus dem Polymerfolienverbund durch Ziehen an der anderen Stirnseite der Maske, an der die Stege noch verbunden sind, entfernt werden kann. Man erhält einen Polymerfolienverbund aus zwei Polymerfolien mit parallelen röhrenförmigen Kanälen, die sich von einer zu der gegenüberliegenden Seite des Polymerfolienverbunds erstrecken.

Erfindungsgemäß kann das Herausziehen der Maske in Schritt d) entweder durch ein Ziehen an und Bewegen der Maske selbst oder durch Ziehen am Polymerverbund erfolgen. Auch können im Schritt d) die Kanäle durch gleichzeitiges Bewegen des Polymerverbunds und durch Ziehen an der Maske freigelegt werden.

Die Breite und Höhe der Kanäle wird erfindungsgemäß durch die Breite und Höhe der Stege der Maske definiert. Dies gilt auch für die Querschnittgeometrie der Kanäle, die durch die Querschnittgestalt der Stege bestimmt wird. Die Breite der Aussparungen in der Maske entspricht im resultierenden Polymerfolienverbund dem Abstand der Kanäle.

In bevorzugten Varianten des erfindungsgemäßen Verfahrens kann vor und/oder nach der elektrischen Aufladung der Oberflächen der Kanäle in Schritt e) die Aufbringung von Elektroden an den äußeren Oberflächen des Polymerverbunds erfolgen. Unter der Aufbringung von Elektroden an den äußeren Oberflächen wird die Bereitstellung einer leitenden Oberflächenbeschichtung in mindestens einem Teilbereich auf den nach außen gerichteten Oberflächen des Polymerverbunds verstanden. Bei den ausgewählten Elektrodenmaterialien kann es sich um dem Fachmann bekannte leitfähige Materialien handeln. Erfindungsgemäß kommen hierfür beispielsweise Metalle, Metall-Legierungen, leitfähige Oligo- oder Polymere, wie z.B.Polythiophene, Polyaniline, Polypyrrole, leitfähige Oxide, wie z.B. Mischoxide wie ITO, oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierte Materialien, wie z.B. Russ, Kohlenstoffnanoröhrchen (Carbonanotubes(CNTs)), oder wiederum leitfähige Oligo- oder Polymere, in Frage. Der Füllstoffgehalt der Polymere liegt dabei oberhalb derPerkolationsschwelle, so dass die leitfähigen Füllstoffe durchgehende elektrisch leitfähige Pfade ausbilden.

Die Elektroden können durch an sich bekannte Verfahren, beispielsweise durch eine Metallisierung der Oberflächen, durch Sputtern, Aufdampfen, Chemical Vapor Deposition (CVD), Drucken, Rakeln, Spin-Coaten, Aufkleben oder Aufdrücken einer leitenden Schicht in vorgefertigter Form oder durch eine Sprühelektrode aus einem leitenden Kunststoff realisiert werden. Die Elektroden können dabei strukturiert, beispielsweise in Streifen oder in Gitterform, ausgestaltet sein.

Die erfindungsgemäßen Ferroelektret-Mehrschichtverbunde enthalten bevorzugt zwei Elektroden. Bei erfindungsgemäßen elektromechanischen Wandlern mit mehr als zwei Elektroden kann es sich beispielsweise um Stapelaufbauten aus mehreren Ferroeletkret-Mehrschichtverbunden handeln. Für die elektrische Aufladung und Polung der inneren Oberflächen der Kanäle kann vorteilhafterweise auf bekannte und etablierte Methoden zurückgegriffen werden. So kann nach der Aufbringung von Elektroden auf den äußeren Oberflächen des Ferroelektret-Mehrschichtverbunds eine direkte Aufladung durch Anlegung einer elektrischen Spannung erfolgen. Vor der Aufbringung von Elektroden kann eine Polung der sich gegenüberliegenden Seiten der Hohlräume, also der Kanäle, beispielsweise durch eine Corona-Entladung realisiert werden. Eine CoronaBehandlung ist vorteilhafterweise auch großtechnisch gut einsetzbar. Erfindungsgemäß ist es auch möglich, zunächst auf einer Oberfläche eine leitende Oberflächenbeschichtung bereitzustellen, den Polymerverbund dann aufzuladen und abschließend eine zweite Elektrode auf der gegenüberliegenden äußeren Oberfläche aufzubringen.

Eine vorteilhafte Ausführungsform der Erfindung sieht vor, dass in Schritt a) der Schichtenstapel eine oder mehrere zusätzliche Polymerfolien und eine oder mehrere Maskenschichten enthält, wobei die äußeren Oberflächen-Schichten des Schichtenstapels immer von Polymerfolien gebildet werden. Vorteilhafterweise kann erfindungsgemäß auch bei einer größeren Anzahl von Polymerfolien und Maskenschichten die Ausbildung von gleichförmigen Kanälen erfolgen.

Eine weiter bevorzugte Ausführungsform sieht dabei vor, die zusätzlichen Polymerfolienschichten und Maskenschichten in alternierender Reihenfolge im Schichtenstapel anzuordnen. Vorteilhafterweise kann somit ein Ferroelektret-Mehrschichtverbund bereitgestellt gestellt werden, der durch die größere Anzahl von Schichten mit mehreren Lagen von parallelen röhrenförmigen Kanälen einen nochmals vergrößerten piezoelektrischen Effekt (d33) zeigen kann.

Die Kanäle in den verschiedenen aufeinanderfolgenden Lagen können dabei parallel oder senkrecht zueinander angeordnet sein. In einer vorteilhaften Weiterentwicklung des Verfahrens können daher die Stege der Masken in aufeinanderfolgenden Lagen parallel oder senkrecht zueinander ausgerichtet sein. Erfindungsgemäß können die Kanäle in einer Gitteranordnung nicht nur im rechten Winkel zueinander angeordnet sein, sondern es sind auch andere Winkelanordnungen zueinander möglich. Erfmdungsgemäß umfasst ist daher auch, dass die Stege nicht nur rechtwinklig zueinander angeordnet, sondern auch weitere Winkeleinstellungen zueinander möglich sind. In der Draufsicht ergeben die aufeinanderfolgenden Maskenschichten in dieser Variante eine Zaun- oder Gitterform. Sind die Stege der Masken in aufeinanderfolgenden Lagen bzw. Maskenschichten parallel zueinander angeordnet, können sie außerdem versetzt zueinander oder direkt übereinander angeordnet sein. Für Sonderanwendungen kann die Gitteranordnung vorteilhaft sein. Bei gleichzeitiger versetzter Anordnung paralleler Kanäle kann eine weitere Lage in Kreuzanordnung vorteilhaft für die Gleichmäßigkeit der Oberfläche sein.

Nach einer weiteren bevorzugten Ausgestaltung des erfindungsgemäßen Verfahrens kann in Schritt b) das Laminieren thermisch oder mittels Ultraschall durchgeführt werden. Hierdurch kann vorteilhafterweise die Materialauswahl für die Polymerfolien noch vergrößert werden.

In einer weiteren bevorzugten Ausgestaltung können die Polymerfolien zusätzlich zur Laminierung durch eine Verklebung miteinander verbunden werden. Diese Verklebung kann beispielsweise mittels Acrylatkleber hergestellt werden. Hierdurch kann die mechanische Verbindung der Polymerfolien unterstützt und verbessert werden.

In einer bevorzugten Ausführungsform sind die Stege der Maske an einer Stirnseite nicht verbunden und die Schritte a), b) und d) können in einem kontinuierlichen Rolle-zu-Rolle-Prozess ausgeführt werden. Diese ist besonders vorteilhaft für die Anwendung des Verfahrens im großtechnischen und industriellen Maßstab. Die Automatisierung zumindest eines Teils des Herstellungsverfahrens vereinfacht das Verfahren nochmals und ermöglicht die kostengünstige Produktion eines Ferroelektret-Mehrschichtverbunds mit parallelen röhrenförmigen Kanälen. Grundsätzlich ist es erfindungsgemäß vorteilhafterweise möglich alle Schritte des Verfahrens, a) bis e) kontinuierlich und/oder automatisiert, beispielsweise als Rolle-zu-Rolle-Prozess durchzuführen.

Die Erfindung betrifft weiterhin ein piezoelektrisches Element enthaltend einen erfindungsgemäßen Ferroelektret-Mehrschichtverbund. Dieses kann besonders bevorzugt ein Sensor- oder Aktorelement sein. Vorteilhafterweise kann die Erfindung in einer Vielzahl von verschiedensten Anwendungen verwirklicht werden. Typische Beispiele hierfür sind Drucksensoren, elektroakustische Wandler, Mikrophone, Lautsprecher und "intelligente" Fußböden.

Zusätzlich wird mit der Erfindung eine Vorrichtung zur Herstellung eines erfindungsgemäßen Ferroelektret-Mehrschichtverbunds vorgeschlagen, die Mittel zur Ausbildung von röhrenförmigen, insbesondere parallel zueinander verlaufenden, Kanälen umfasst.

Bevorzugt ist dabei, dass die Mittel zur Ausbildung von parallelen röhrenförmigen Kanälen eine Maske umfassen, wobei die Maske zwei oder mehr voneinander durch Aussparungen beabstandete, insbesondere parallele, Stege aufweist, wobei die Stege auf mindestens einer Stirnseite nicht verbunden oder voneinander trennbar verbunden sind.

Die Maske ist nach der Erfindung zweckgemäß aus einem Material gefertigt, das sich unter den jeweils gewählten Betriebsbedingungen nicht mit dem Polymerfolienmaterial verbindet. Die Maske kann erfindungsgemäß bevorzugt aus einem Polymermaterial, einem metallischen Material und/oder einem Verbundmaterial gefertigt sein. Ein Verbundmaterial umfasst erfindungsgemäß auch, dass das Polymermaterial oder das metallische Material der Maske mit einer Antihaftbeschichtung versehen sein kann, die die Entfernung der Maske aus dem Polymerfolienverbund vereinfacht. Ist die Maske mindestens teilweise aus einem metallischen und magnetischen Material gefertigt, können die Stege in einer weiteren vorteilhaften Ausgestaltung durch eine geeignete Anordnung von Magneten oder magnetischen Bauteilen in der erfindungsgemäßen Vorrichtung in Position und in Form gehalten werden. Hierdurch kann die Standzeit der Vorrichtung verlängert und die Qualität der erzeugten Ferroelektret-Polymerverbunde verbessert und über einen verlängerten Zeitraum sichergestellt und aufrecht erhalten werden.

Die Erfindung betrifft zudem eine Vorrichtung zur Durchführung eines Verfahrens, die mindestens die folgenden Komponenten enthält
a) eine Laminiereinheit,
b) eine Maske mit zwei oder mehreren voneinander durch Aussparungen beabstandeten, parallelen Stegen, wobei die Stege mindestens teilweise innerhalb der Laminiereinheit angeordnet sind,
c) jeweils eine oder mehrere Zuführ-Einrichtungen zur kontinuierlichen Zuführung mindestens einer Polymerfolie oberhalb und mindestens einer Polymerfolie unterhalb der Maske zur Bildung eines Schichtenstapels, und wobei weiterhin
d) die Stege der Maske auf der Stirnseite, die den Zuführ-Einrichtungen zugewandt ist, miteinander verbunden und auf der gegenüberliegenden Stirnseite voneinander getrennt sind.

Vorteilhafterweise kann mit der Vorrichtung das Verfahren mindestens teilweise als kontinuierlicher Prozess auch in großtechnischem Maßstab, vorzugsweise als Rolle-zu-Rolle-Prozess, durchgeführt werden. Dies ist besonders vorteilhaft für die Anwendung des Verfahrens im industriellen Maßstab. Die Automatisierung zumindest eines Teils des Herstellungsverfahrens vereinfacht das Verfahren nochmals und ermöglicht die kostengünstige Produktion eines Ferroelektret-Mehrschichtverbunds mit parallelen röhrenförmigen Kanälen.

In einer vorteilhaften Weiterentwicklung kann die Laminier-Einheit eine oder mehrere strukturierte Laminierwalzen aufweisen. Die Strukturierung kann vorteilhafterweise so gestaltet sein, das ein höherer Druck auf die zu verbindenden Bereiche der Polymerfolien ausgeübt und die Verbindung der Polymerfolien auf diese Weise verbessert werden kann. Alternativ oder zusätzlich kann die Strukturierung der Laminierwalzen auch so gestaltet sein, dass beispielsweise Vorwölbungen auf der Walzenoberfläche in die Aussparungen zwischen den Stegen eingreifen und die Stege umfassen und in Position halten und vorteilhafter Weise die Standzeit der Vorrichtung verlängern.

Insgesamt kann die Qualität des erzeugten Ferroelektret-Mehrschichtverbunds durch die Strukturierung der Laminierwalze nochmals verbessert werden.

Sind zumindest die Stege der Maske aus metallischem und magnetischem Material ausgebildet, kann erfindungsgemäß weiterhin vorgesehen sein, dass die Laminiereinheit ober- und unterhalb der Stege magnetische Elemente aufweist. Vorteilhafterweise können durch diese Maßnahme die Stege in der gewünschten Position gehalten werden. Dies trägt zur Formstabilität und Haltbarkeit der Maske bei. Hierdurch kann die Qualität der erzeugten Ferroelektret-Mehrschichtverbund-Produkte erhöht und über einen längeren Zeitraum erhalten und gewährleistet werden.

Die Erfindung wird nachfolgend in beispielhafter Weise in Verbindung mit den Figuren erläutert, ohne auf diese Ausführungsformen beschränkt zu sein.

In diesen zeigt:
Fig. 1 eine schematische Ansicht eines erfindungsgemäßen Ferroelektret-Mehrschichtverbunds aus zwei Polymerfolien im Querschnitt,
Fig. 2 eine Draufsicht auf einen erfindungsgemäßen Schichtenstapel aus zwei Polymerfolien mit einer Maskenschicht,
Fig 3a eine Abbildung eines erfindungsgemäß hergestellten Ferroelektret-Mehrschichtverbunds aus zwei Polycarbonatfolien in der Draufsicht;
Fig. 3b eine Abbildung eines erfindungsgemäß hergestellten Ferroelektret-Mehrschichtverbunds aus zwei Polycarbonatfolien im Querschnitt,
Fig. 4 als Abbildung einen Ausschnitt eines erfindungsgemäß hergestellten Ferroelektret-Mehrschichtverbunds aus drei Polycarbonatfolien im Querschnitt und
Fig. 5 eine schematische Darstellung einer Vorrichtung zur Durchführung des erfindungsgemäßen Verfahrens.

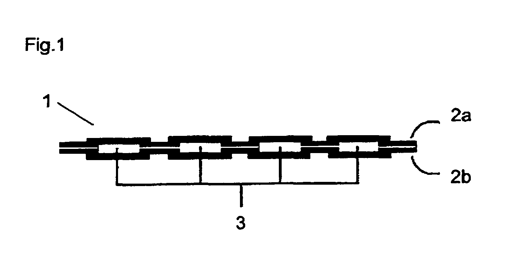

Die Fig. 1 zeigt eine schematische Ansicht eines erfindungsgemäßen Ferroelektret-Mehrschichtverbunds 1 aus zwei Polymerfolien 2a, 2b im Querschnitt. Zwischen den Polymerfolien 2a, 2b ist eine Lage parallel zueinander angeordneter röhrenförmiger Kanäle 3 ausgebildet. Die Kanäle 3 weisen einen rechteckigen Querschnitt auf. Diese Querschnittsform ist vorteilhafterweise besonders einfach herzustellen. Die Polymerfolien 2a, 2b sind zwischen den Kanälen miteinander verbunden und nur zur Verdeutlichung getrennt dargestellt.

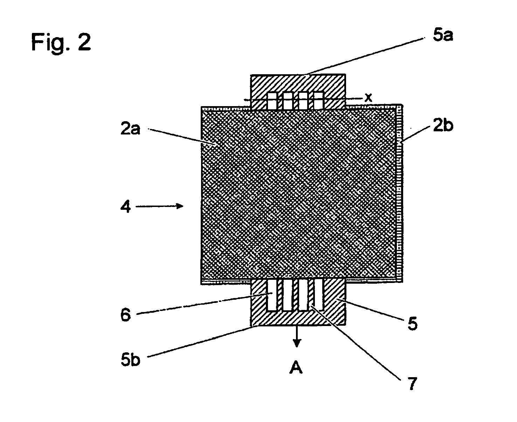

Die Fig. 2 zeigt eine Draufsicht auf einen erfindungsgemäßen Schichtenstapel 4 aus zwei Polymerfolien 2a, 2b mit einer Maskenschicht 5 und illustriert zudem eine einfache Möglichkeit, den in Fig.1 gezeigten Ferroelektret-Mehrschichtverbund 1 herzustellen. Die Maskenschicht 5 kann ein Polymerfolienblatt, beispielsweise aus Polytetrafluoroethylen (PTFE) sein, in das parallele lang gestreckte rechteckige Aussparungen 6 eingeschnitten oder gestanzt sind, so dass die Stege 7 als parallele Folien-Streifen ausgebildet werden, die zu beiden Stirnseiten 5a, 5b der Masken-Polymerfolie 5 miteinander verbunden sind. Dies hat den Vorteil, dass die Stege 7 an beiden Stirnseiten 5a, 5b der Maske 5 fixiert sind und gerade bei einer manuellen Handhabung und Durchführung des Verfahrens nicht verrutschen oder verformt werden. Die Stirnseiten 5a, 5b der Maskenfolie 5 ragen aus dem gebildeten Schichtenstapel 4 heraus. Der Schichtenstapel 4 kann nachfolgend bei einer geeigneten erhöhten Temperatur laminiert werden. Hierbei verbinden sich die Polymerfolien 2a, 2b in den Aussparungen 6 der Maske 5 und bilden die Form der Stege 7 ab. Zu einer Stirnseite 5a können die Stege dann, beispielsweise durch einfaches Abschneiden, entlang der gestrichelten Linie X, voneinander getrennt werden. Die Maske 5 erhält dadurch eine kammartige Form und kann leicht in Richtung des Pfeils A aus dem Polymerfolienverbund herausgezogen und entfernt werden. Man erhält einen Polymerfolienverbund 1 aus zwei Polymerfolien 2a, 2b mit parallelen röhrenförmigen Kanälen 3, die sich von einer Seite des Polymerfolienverbunds zur gegenüberliegenden Seite des Polymerfolienverbunds durchgehend erstrecken.

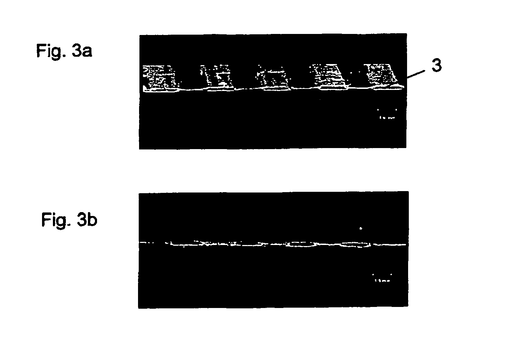

Die Fig. 3a zeigt eine Abbildung eines erfindungsgemäß analog dem in der Beschreibung zu der Fig. 2 beschriebenen Verfahren hergestellten Ferroelektret-Mehrschichtverbunds 1 aus zwei Polycarbonatfolien mit fünf ausgebildeten parallelen röhrenförmigen Kanälen 3, die mit einem Stereo-Lichtmikroskop aufgenommen wurde.

Die Fig. 3b zeigt eine mit einem Stereo-Lichtmikroskop aufgenommene Abbildung eines ebenfalls gemäß der Beschreibung zu Fig. 2 hergestellten Ferroelektret-Mehrschichtverbunds 1 aus zwei Polycarbonatfolien mit vier parallelen röhrenförmigen Kanälen 3.

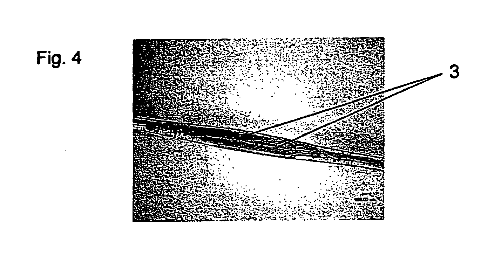

Fig. 4 zeigt als Lichtmikroskop-Abbildung einen Ausschnitt eines erfindungsgemäß hergestellten Ferroelektret-Mehrschichtverbunds 1 aus drei Polycarbonatfolien im Querschnitt. Der Ausschnitt zeigt zwei in aufeinanderfolgenden Lagen parallel zueinander angeordnete Kanäle 3. Die gezeigten Kanäle 3 in den aufeinanderfolgenden Lagen sind parallel ausgerichtet und etwas versetzt zueinander angeordnet.

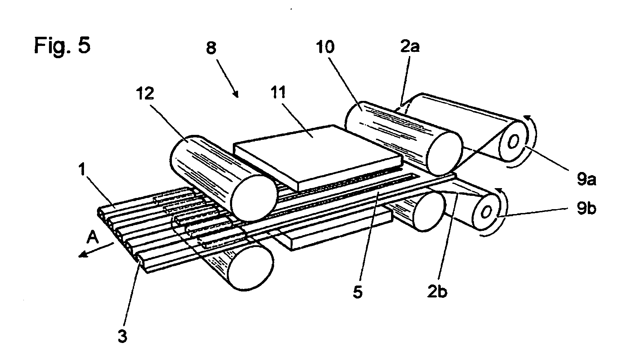

Die Fig. 5 zeigt eine schematische Darstellung einer Vorrichtung 8 zur Durchführung der Schritte a), b) und d) des erfindungsgemäßen Verfahrens in einem Rolle-zu-Rolle-Prozess. Als Zuführ-Einrichtungen werden eine erste und eine zweite Zuführrolle 9a, 9b zur kontinuierlichen Zuführung mindestens einer Polymerfolie 2a oberhalb und mindestens einer Polymerfolie 2b unterhalb der Maske 5 zur Bildung eines Schichtenstapels 4 eingesetzt. Die Begriffe "oben" und "unten" bzw. "oberhalb" und " unterhalb" bezeichnen dabei jeweils nur die Lage zueinander und sind gegebenenfalls austauschbar. Die Stege der Maske 5 auf der Stirnseite, die den Zuführrollen 9a, 9b zugewandt ist, sind miteinander verbunden und auf der gegenüberliegenden Stirnseite voneinander getrennt. Grundsätzlich sind auch andere Ausrichtungen der Maske, beispielsweise eine Anordnung im rechten Winkel zur Produktionsrichtung, denkbar. Weiterhin beinhaltet die gezeigte Vorrichtung 8 eine Laminiereinheit, die jeweils oberhalb und unterhalb der Maske 5 in Produktionsrichtung aus ersten Laminierwalzen 10, einer Heizeinrichtung 11 und zweiten Laminierwalzen 12 gebildet wird. In der Laminiereinheit werden die Polymerfolien 2a, 2b in den Aussparungen 6 der Maske 5 zusammengepresst und unter Ausbildung der Kanäle 3 miteinander verbunden. Der gebildete Polymerverbund 1 mit röhrenförmigen Kanälen 3 kann dann kontinuierlich in Richtung des Pfeils A gezogen und abtransportiert und werden. So kann ein Mehrschichtverbund mit sozusagen endlos langen Kanälen 3 entstehen. Die Dimensionierung und der Abstand der Kanäle können durch eine entsprechende Ausgestaltung der Maske 5 bestimmt werden. Ein immenser Vorteil ist, dass der vorgestellte Prozess in weiten Bereichen materialunabhängig ist und hierdurch weitergehend eine breite Anwendungsmöglichkeit ermöglicht. Vorteilhafterweise kann mit der erfindungsgemäßen Vorrichtung das Verfahren mindestens teilweise als kontinuierlicher Prozess auch in großtechnischem Maßstab als Rolle-zu-Rolle-Prozess durchgeführt werden, wobei es grundsätzlich vorteilhafterweise möglich ist sämtliche Verfahrensschritte, dass heißt auch die Polung der inneren Kanal-Oberflächen kontinuierlich und/oder automatisiert durchzuführen. Dies ist besonders vorteilhaft für die Anwendung des Verfahrens im industriellen Maßstab. Die Automatisierung zumindest eines Teils des Herstellungsverfahrens vereinfacht das Verfahren und ermöglicht die kostengünstige Produktion eines Ferroelektret-Mehrschichtverbunds mit parallelen röhrenförmigen Kanälen 3.

Zusammenfassend wird erfindungsgemäß ein Verfahren zur Herstellung eines Ferroelektret-Mehrschichtverbunds mit röhrenförmigen Kanälen bereitgestellt, das einfach und kostengünstig auch im großtechnischen Maßstab durchgeführt werden kann. Die mit dem erfindungsgemäßen Verfahren erzeugten Ferroelektret-Mehrschichtaufbauten können auch bei einer größeren Anzahl von Schichten mit genau definierter Hohlraumstruktur hergestellt werden. Durch die variable Einstellbarkeit der Querschnittgeometrie und der Dimensionierung und durch die Anzahl der erfindungsgemäß erzeugten röhrenförmigen Kanäle, die Schichtenabfolge und Lagenanzahl der röhrenförmigen Kanäle sowie durch die große Materialauswahl für die eingesetzten Polymerfolien können die erfindungsgemäß erzeugten Ferroelektrete besonders gut auf entsprechende Anwendungsgebiete eingestellt werden.

Durch die nachfolgend aufgeführten Beispiele soll die Erfindung weiter erläutert werden, ohne auf diese beschränkt zu sein.

### Beispiele

### Beispiel 1

### Herstellung eines Ferroelektret-Mehrschichtverbunds aus Polycarbonat-Folien

Zwischen zwei Polymerfolienblätter aus Polycarbonat wurde als Maske ein Polymerfolienblatt, aus PTFE eingelegt. Die Polycarbonatfolien wiesen jeweils eine Dicke von 50 µm auf. In die Maske waren zueinander parallele lang gestreckte rechteckige Aussparungen eingeschnitten, so dass die Stege als parallele Folien-Streifen mit 1,3 mm Breite ausgebildet wurden, die zu beiden Stirnseiten der Maske miteinander verbunden waren. Die Maske ragte mit ihren Stirnseiten aus dem gebildeten Schichtenstapel heraus. Die Maskenfolie wies eine Dicke von 200 µm auf. Der Schichtenstapel wurde nachfolgend bei einer Temperatur von 180 °C laminiert. Hierbei verbanden sich die Polycarbonatfolien im Bereich der Aussparungen der Maske und bildeten die Form der Stege ab. An einer Stirnseite wurden die Stege durch einfaches Abschneiden der Stirnseite der Maskenfolie voneinander getrennt. Die Maske erhielt hierdurch eine kammartige Form und konnte durch Ziehen an der anderen Stirnseite, an der die Stege noch verbunden waren, leicht aus dem Polycarbonatfolienverbund entfernt werden. Man erhielt einen Polymerfolienverbund aus zwei Polycarbonatfolien mit durchgehenden parallelen röhrenförmigen Kanälen. Die Breite und Höhe der Kanäle wurde durch die Breite und Höhe der Stege definiert. Die Höhe der Kanäle betrug 200 µm. Die Polycarbonatfolien wurden nachfolgend an ihren nach außen gerichteten Oberflächen mit Aluminiumelektroden von 50 nm Dicke versehen und mittels direkt angelegter elektrischer Spannung von 3kV gepolt.

Der piezoelektrische d33 Koeffizient wurde nach 2 Wochen gemessen.
- d33 Polycarbonat Probe 1:: 350 pC/N
- d33 Polycarbonat Probe 2:: 600 pC/N

### Beispiel 2

### Herstellung eines Ferroelektret-Mehrschichtverbunds aus FEP-Folien

Die Herstellung des Ferroelektret-Mehrschichtverbunds wurde analog zu Beispiel 1 mit FEP-Folien mit einer Dicke von 50 µm und einer Maske aus PTFE mit einer Dicke von 200µm und Stegbreiten von 1,3 mm durchgeführt. Die Verbindung der FEP-Folien durch Laminierung erfolgte bei einer Temperatur von 300 °C. Der piezoelektrische d33 Koeffizient wurde nach 2 Wochen gemessen.

In analoger Weise wurden weitere Ferroelektret-Mehrschichtverbund-Proben aus 50 µm dicken FEP-Folien und mit PTFE-Maskenschichten mit Dicken von 25 µm, 50 µm, 100 µm, 200 µm und 300 µm hergestellt. Es wurden jeweils zu jeder eingesetzten Maskenschichtdicke 10 Proben gefertigt. Die Polymerfolienstücke hatten dabei eine Größe von 4 cm x 4 cm bis 10 cm x 13 cm. Jede Probe wurde nach 2 Wochen 5 Mal gemäß der Vorgehensweise in Beispiel 3 vermessen. Aus allen Werten wurden dann ein Mittelwert und eine Standardabweichung bestimmt, die in der folgenden Tabelle 1 wiedergegeben sind.

**Tabelle 1**

| Kanalhöhe [µm] | d33 Mittelwert [pC/N] | d33 Standardabweichung [pC/N (±)] |
|---|---|---|
| 25 | 27.4 | 6.4 |
| 50 | 79.4 | 9.13 |
| 70 | 55.8 | 13.14 |
| 100 | 107.6 | 35.84 |
| 200 | 56.2 | 13.96 |
| 300 | 43.1 | 15.43 |

### Beispiel 3

### Versuchsaufbau für die mechanische Messung der d33-Piezokonstanten und Durchführung der Messungen

Für die Messeinrichtung werden grundsätzlich folgende drei Hauptkomponenten benötigt: Krafterzeuger, Kraftmessgerät und Ladungsmessegerät. Als Krafterzeuger wurde ein elektrischer Schwingerreger Typ 4810 von Brüel & Kjær gewählt. Der Schwingerreger ermöglicht es, eine definierte Kraft in Abhängigkeit von der Eingangsspannung auszuüben. Dieser Schwingerreger wurde an einer beweglichen Plattform montiert, deren Position in vertikaler Richtung manuell einstellbar ist. Die Höhenverstellbarkeit des Schwingerregers ist zum Einspannen der Proben notwendig. Außerdem kann damit der statische Vordruck, der für die Messung erforderlich ist, eingestellt werden. Zur Steuerung des Schwingerregers wurde ein Funktionsgenerator DS 345 von Stanford Research Systems in Verbindung mit einem Leistungsverstärker Typ 2718 von Brüel & Kjær benutzt. Als Kraftmessgerät wurde ein Kraftsensor Typ 8435 von Burster verwendet. Der Kraftsensor ist sowohl auf Druck- als auch auf Zugmessungen im Bereich von 0 bis 200 N ausgelegt. Die Krafteinwirkung darf allerdings nur senkrecht erfolgen, so dass keine seitliche Kraftkomponenten oder Drehmomente auf den Sensor einwirken. Um dies zu gewährleisten, wurde der Kraftsensor mit einer zylinderförmigen Druckführungsschiene mit einem darin beinahe reibungslos gleitenden Bolzen aus Edelstahl versehen. Am freien Ende des Bolzens befand sich eine zwei Zentimeter breite polierte Platte, die als Auflagefläche für die Proben diente. Die Signale vom Kraftsensor werden mit einem Modulverstärker Typ 9243 von Burster erfasst und weiter an ein Oszilloskop GOULD 4094 geleitet.

Als Ladungsmessgerät wurde ein Ladungsverstärker Typ 2635 von Brüel & Kjær verwendet. Der Ladungsverstärker ermöglicht es, Ladungen bis zu 0,1 pC zu erfassen. Für die Messung der Oberflächenladung müssen die beiden Seiten der Probe mit dem Ladungsverstärker elektrisch verbunden sein. Der elektrische Kontakt zu der unteren Seite der Probe wird durch die Auflagefläche ermöglicht, die ihrerseits mit dem gesamten Aufbau verbunden ist. Die obere Seite der Probe wurde durch den Druck-ausübenden Stempel aus Messing mit dem Ladungsverstärker verbunden. Der Stempel wird durch einen Aufsatz aus Plexiglas am Schwingerreger von dem restlichen Aufbau elektrisch isoliert und durch ein Kabel mit dem Ladungsverstärker verbunden. Das Kabel sollte möglichst dünn und weich sein, um mechanische Spannungen und damit Verfälschungen der Messergebnisse zu vermeiden. Das gemessene Signal wird schließlich vom Ladungsverstärker zum Oszilloskop weitergeleitet.

Standardmäßig wurde ein Vordruck von 3 N (statisch) eingestellt und mit einer Amplitude von 1 N (dynamisch) gemessen.

## Patentansprüche

1. Ferroelektret-Mehrschichtverbund umfassend mindestens zwei übereinander angeordnete und miteinander verbundene Polymerfolien, wobei zwischen den Polymerfolien Hohlräume ausgebildet sind, **dadurch gekennzeichnet, dass** die Hohlräume röhrenförmige Kanäle sind.

2. Ferroelektret-Mehrschichtverbund nach Anspruch 1 **dadurch gekennzeichnet, dass** die Hohlräume parallel zueinander verlaufende röhrenförmige Kanäle sind.

3. Ferroelektret-Mehrschichtverbund nach Anspruch 1 **dadurch gekennzeichnet, dass** die Polymerfolien aus gleichen oder unterschiedlichen Polymermaterialien ausgewählt aus der Gruppe der Polycarbonate, Fluor-Polymere und -Copolymere, Polyester, Polyimide, Polymethylmethacrylat, Cyclo-Olefin-Polymere, Cyclo-Olefin-Copolymere und Polypropylen bestehen.

4. Ferroelektret-Mehrschichtverbund nach Anspruch 1 **dadurch gekennzeichnet, dass** drei oder mehr Polymerfolien übereinander angeordnet und miteinander verbunden sind und die röhrenförmigen Kanäle zwischen den Polymerfolien in übereinander angeordneten Lagen parallel oder senkrecht zueinander angeordnet sind

5. Ferroelektret-Mehrschichtverbund nach Anspruch 1 **dadurch gekennzeichnet, dass** die Kanäle (3) zu ihren Stirnseiten hin offen oder ein- oder beidseitig geschlossen sind.

6. Ferroelektret-Mehrschichtverbund nach Anspruch 1 **dadurch gekennzeichnet, dass** auf den nach außen gerichteten Oberflächen der Polymerfolien mindestens teilweise eine leitende Beschichtung aufgebracht ist.

7. Verfahren zur Herstellung eines Ferroelektret-Mehrschichtverbunds mit parallelen röhrenförmigen Kanälen **gekennzeichnet durch** die folgenden Schritte:
a) Bereitstellen eines Schichtenstapels enthaltend eine erste Polymerfolie, eine zweite Polymerfolie und eine dazwischen angeordnete Maskenschicht, wobei die Maske innerhalb des Schichtenstapels einen oder mehrere voneinander **durch** Aussparungen beabstandete, parallele Stege aufweist, wobei die Stege auf mindestens einer Stirnseite nicht verbunden oder voneinander trennbar verbunden sind und die Maske an einer oder beiden Stirnseiten aus dem Schichtstapel herausragt,
b) Laminieren des in Schritt a) erzeugten Schichtenstapels und Verbinden der Polymerfolien zu einem Polymerfolienverbund,
c) Gegebenenfalls Trennen der Stege der Maske an einer Stirnseite,
d) Entfernen der Maske aus dem Polymerfolienverbund **durch** Herausziehen der Maske aus dem Polymerfolienverbund,
e) Elektrische Aufladung der inneren Oberflächen der in Schritt d) freigegebenen röhrenförmigen Kanäle mit entgegengesetzten elektrischen Ladungen.

8. Verfahren nach Anspruch 7 **dadurch gekennzeichnet, dass** vor und/oder nach der elektrischen Aufladung der inneren Oberflächen der Kanäle in Schritt e) die Aufbringung von Elektroden an den äußeren Oberflächen des Polymerverbunds erfolgt.

9. Verfahren nach Anspruch 7 **dadurch gekennzeichnet, dass** in Schritt a) der Schichtenstapel eine oder mehrere zusätzliche Polymerfolien und eine oder mehrere Maskenschichten enthält, wobei die äußeren Schichten des Schichtenstapels von Polymerfolien gebildet werden.

10. Verfahren nach Anspruch 9 **dadurch gekennzeichnet, dass** die zusätzlichen Polymerfolien und Maskenschichten in alternierender Reihenfolge im Schichtenstapel angeordnet sind.

11. Verfahren nach Anspruch 7 **dadurch gekennzeichnet, dass** die Stege der Maske an einer Stirnseite nicht verbunden sind und die Schritte a), b) und d) als kontinuierlicher Rolle-zu-Rolle-Prozess durchgeführt werden.

12. Piezoelektrisches Element enthaltend einen Ferroelektret-Mehrschichtverbund nach einem der Ansprüche 1 bis 6.

13. Piezoelektrisches Element nach Anspruch 12 **dadurch gekennzeichnet, dass** es ein Sensor- oder Aktorelement ist.

14. Vorrichtung zur Durchführung eines Verfahrens nach Anspruch 7 oder 11 **dadurch gekennzeichnet, dass** sie mindestens die folgenden Komponenten enthält
a. eine Laminiereinheit,
b. eine Maske mit zwei oder mehreren voneinander durch Aussparungen beabstandeten, parallelen Stegen, wobei die Stege mindestens teilweise innerhalb der Laminiereinheit angeordnet sind,
c. jeweils eine oder mehrere Zuführ-Einrichtungen zur kontinuierlichen Zuführung mindestens einer Polymerfolie oberhalb und mindestens einer Polymerfolie unterhalb der Maske zur Bildung eines Schichenstapels, und weiterhin
d. die Stege der Maske auf der Stirnseite, die den Zuführ-Einrichtungen zugewandt ist, miteinander verbunden und auf der gegenüberliegenden Stirnseite voneinander getrennt sind.

## Claims

1. Ferroelectret multilayer composite comprising at least two mutually superposed polymer films bonded to one another, where cavities have formed between the polymer films, **characterized in that** the cavities are tubular channels.

2. Ferroelectret multilayer composite according to Claim 1, **characterized in that** the cavities are tubular channels running parallel to one another.

3. Ferroelectret multilayer composite according to Claim 1, **characterized in that** the polymer films are composed of identical or different polymer materials selected from the group of the polycarbonates, fluoropolymers and fluorocopolymers, polyesters, polyimides, polymethyl methacrylate, cycloolefin polymers, cycloolefin copolymers and polypropylene.

4. Ferroelectret multilayer composite according to Claim 1, **characterized in that** there are three or more mutually superposed polymer films bonded to one another, and the arrangement has the tubular channels between the polymer films in mutually superposed sublayers parallel or perpendicular to one another.

5. Ferroelectret multilayer composite according to Claim 1, **characterized in that** the channels (3) have their ends open or have one or both ends closed.

6. Ferroelectret multilayer composite according to Claim 1, **characterized in that** at least to some extent there is a conductive coating applied on the outwardly facing surfaces of the polymer films.

7. Process for producing a ferroelectret multilayer composite with parallel tubular channels, **characterized by** the following steps:
a) providing a layer stack comprising a first polymer film, a second polymer film and a mask layer arranged therebetween, where the mask within the layer stack has one or more parallel fillets separated from one another by cut-outs, where the fillets at at least one end are unconnected or connected so as to be separable from one another and the mask protrudes at one or both ends out of the layer stack,
b) laminating the layer stack produced in step a) and bonding the polymer films to give a polymer film composite,
c) optionally separating the fillets of the mask at one end,
d) removing the mask from the polymer film composite by withdrawing the mask from the polymer film composite,
e) electrical charging of the inner surfaces of the tubular channels uncovered in step d), with opposite electrical charges.

8. Process according to Claim 7, **characterized in that** prior to and/or after the electrical charging of the inner surfaces of the channels in step e), electrodes are applied on the exterior surfaces of the polymer composite.

9. Process according to Claim 7, **characterized in that**, in step a), the layer stack comprises one or more additional polymer films and one or more mask layers, where the exterior layers of the layer stack are formed by polymer films.

10. Process according to Claim 9, **characterized in that** the arrangement has the additional polymer films and mask layers in alternating sequence in the layer stack.

11. Process according to Claim 7, **characterized in that** the fillets of the mask have not been bonded at one end, and the steps a), b) and d) are carried out as continuous roll-to-roll process.

12. Piezoelectric element comprising a ferroelectret multilayer composite according to any of Claims 1 to 6.

13. Piezoelectric element according to Claim 12, **characterized in that** it is a sensor element or actuator element.

14. Apparatus for carrying out a process according to Claim 7 or 11, **characterized in that** it comprises at least the following components
a. a laminating unit,
b. a mask with two or more parallel fillets separated from one another by cut-outs, where the arrangement has the fillets at least to some extent within the laminating unit,
c. respectively one or more feed devices for continuously feeding at least one polymer film above, and at least one polymer film below, the mask, to form a layer stack, and moreover
d. there is connection between the fillets of the mask at the end facing towards the feed devices, and at the opposite end the fillets are separate from one another.

## Revendications

1. Composite multicouche à ferroélectret comprenant au moins deux feuilles polymères disposées l'une sur l'autre et liées l'une à l'autre, des espaces creux étant formés entre les feuilles polymères, **caractérisé en ce que** les espaces creux sont des canaux tubulaires.

2. Composite multicouche à ferroélectret selon la revendication 1, **caractérisé en ce que** les espaces creux sont des canaux tubulaires s'étendant parallèlement les uns aux autres.

3. Composite multicouche à ferroélectret selon la revendication 1, **caractérisé en ce que** les feuilles polymères sont constituées par les mêmes matériaux polymères ou des matériaux polymères différents choisis dans le groupe des polycarbonates, des polymères et copolymères fluorés, des polyesters, des polyimides, du poly(méthacrylate de méthyle), des polymères cyclooléfiniques, des copolymères cyclooléfiniques et du polypropylène.

4. Composite multicouche à ferroélectret selon la revendication 1, **caractérisé en ce que** trois feuilles polymères ou plus sont disposées les unes sur les autres et reliées les unes aux autres et les canaux tubulaires sont disposés entre les feuilles polymères dans des épaisseurs disposées les unes sur les autres, parallèlement ou perpendiculairement les uns aux autres.

5. Composite multicouche à ferroélectret selon la revendication 1, **caractérisé en ce que** les canaux (3) sont ouverts ou fermés d'un ou des deux côtés en leurs faces frontales.

6. Composite multicouche à ferroélectret selon la revendication 1, **caractérisé en ce qu'**un revêtement conducteur est appliqué au moins partiellement sur les surfaces orientées vers l'extérieur des feuilles polymères.

7. Procédé pour la fabrication d'un composite multicouche à ferroélectret présentant des canaux tubulaires parallèles, **caractérisé par** les étapes suivantes :
a) préparation d'une pile de couches contenant une première feuille polymère, une deuxième feuille polymère et une couche à masques disposée entre celles-ci, le masque présentant, dans la pile de couches, une ou plusieurs âmes parallèles, distancées les unes des autres par des évidements, les âmes n'étant pas liées les unes aux autres ou liées en pouvant être séparées les unes des autres sur au moins une face frontale et le masque sortant sur une ou les deux faces frontales de la pile de couches,
b) laminage de la pile de couches produite dans l'étape a) et assemblage des feuilles polymères en un composite de feuilles polymères,
c) le cas échéant séparation des âmes du masque en une face frontale,
d) élimination du masque du composite de feuilles polymères en retirant le masque du composite de feuilles polymères,
e) chargement électrique des surfaces internes des canaux tubulaires mis à nu dans l'étape d) par des charges électriques opposées.

8. Procédé selon la revendication 7, **caractérisé en ce qu'**on réalise l'application d'électrodes au niveau des surfaces externes du composite polymère avant et/ou après le chargement électrique des surfaces internes des canaux dans l'étape e).

9. Procédé selon la revendication 7, **caractérisé en ce que** dans l'étape a), la pile de couches contient une ou plusieurs feuilles polymères supplémentaires et une ou plusieurs couches à masques, les couches externes de la pile de couches étant formées par des feuilles polymères.

10. Procédé selon la revendication 9, **caractérisé en ce que** les feuilles polymères supplémentaires et les couches à masques sont disposées dans un ordre en alternance dans la pile de couches.

11. Procédé selon la revendication 7, **caractérisé en ce que** les âmes du masque ne sont pas reliées en une face frontale et les étapes a), b) et d) sont réalisées comme un procédé continu de rouleau-à-rouleau.

12. Elément piézoélectrique contenant un composite multicouche à ferroélectret selon l'une quelconque des revendications 1 à 6.

13. Elément piézoélectrique selon la revendication 12, **caractérisé en ce qu'**il s'agit d'un élément à capteur ou d'un élément actionneur.

14. Dispositif pour réaliser un procédé selon la revendication 7 ou 11, **caractérisé en ce qu'**il contient au moins les composants suivants :
a. une unité de laminage,
b. un masque présentant deux âmes parallèles ou plus, distancées les unes des autres par des évidements, les âmes étant disposées au moins partiellement dans l'unité de laminage,
c. à chaque fois un ou plusieurs dispositifs d'alimentation pour l'alimentation continue d'au moins une feuille polymère au-dessus et d'au moins une feuille polymère au-dessous du masque pour former une pile de couches, et en outre
d. les âmes du masque, sur la face frontale orientée vers les dispositifs d'alimentation, étant reliées les unes aux autres et séparées les unes des autres sur la face frontale opposée.
